# EUROPÄISCHE PATENTSCHRIFT

(11) **EP 1 148 556 B1**
(45) Veröffentlichungstag und Bekanntmachung des Hinweises auf die Patenterteilung: **03.02.2010**
(21) Anmeldenummer: 01104122.5
(22) Anmeldetag: 21.02.2001
(51) Int. Cl.: G11C 16/16, G11C 16/14

(54) **Methode zum Löschen einer Split-gate Flash Speicherelementeanordnung**
Method of erasing a split-gate flash memory element arrangement
Méthode d'éffacement d'un arrangement d'élements de mémoire flash à grilles reparties

(30) Priorität: 22.02.2000 DE 10008002
(43) Veröffentlichungstag der Anmeldung: 24.10.2001
(73) Patentinhaber: X-FAB Semiconductor Foundries AG, 99097 Erfurt (DE)
(72) Erfinder: Frey, Michael, 99094 Erfurt (DE); Haberla, Holger Dr., 99448 Kranichfeld, OT Stedten (DE)
(74) Vertreter: Leonhard, Frank Reimund

(56) Entgegenhaltungen:
- US-A- 5 341 342
- US-A- 5 418 742
- US-A- 5 790 460
- US-A- 5 998 826

## Beschreibung

Die Erfindung betrifft ein Verfahren eines Split-gate Flash-Speicherelementes und dabei eine Methode zum Löschen, dies bei einer speziellen Doppelwannentechnologie in einem Hochvoltprozess.

Bekannt sind Anordnungen von Flash-Speicherzellen im Substrat, deren Methoden zum Löschen darin bestehen, hohe negative Spannungen an allen Gates der Speicherzellen und/oder hohe positive Spannungen an den Drains der Speicherzellen anzulegen, um den gewünschten Tunneleffekt von Ladungsträgern aus dem Floating Gate zu initiieren, welcher notwendig ist, um die Speicherzellen zu löschen. Die negativen Spannungen, z.B. -8V, werden über Dekoder an die Gates geschaltet, wodurch sich der Einsatz komplementärer Schaltungstechniken verbietet. Ausschließlich p-Kanal Transistoren sind zum Schalten negativer Spannungen geeignet, wobei an den Gates dieser p-Kanaltransistoren eine um mindestens die Schwellspannung höhere noch negativere Spannung, z.B. -12V, angelegt werden muß. Für das Lesen der Speicherzellen darf aus Gründen der Selektion nur an den Gates der ausgewählten Speicherzellen eine positive Spannung anliegen, während alle anderen Gates auf 0V gelegt werden müssen. Diese 0V können wiederum nur dann über die p-Kanal Transistoren in den Dekodern zugeschaltet werden, wenn an den Gates dieser p-Kanal Transistoren wieder eine um mindestens die Schwellspannung niedrigere Spannung anliegt, z.B. -3V.

Aus der US 5,341,342 B1 (National Semiconductor Corporation) ist eine Halbleiterzelle bekannt, die als Flash Memory Cell benannt wird. Sie besitzt ein Floating Gate und hat ein erstes isoliertes Polysiliziumgate, welches durch ein Tunneloxid, dort Abbildung 3, Referenz 40, von der Oberfläche des Halbleiters elektrisch getrennt ist. Das Substrat, dort Abbildung 3, Bezugszeichen 26, der Drainschluss und der Sourceanschluss werden auf Massepotential gelegt. Die tiefe n - Wanne, dort Abbildung 3, Bezugszeichen 28, und eine flache p-Wanne, dort Abbildung 3, Bezugszeichen 30, werden auf ein niedriges Potential gelegt, und das zweite Gate, dort Abbildung 3, Bezugszeichen 38, wird auf ein hohes negatives Potential gelegt.

Der Erfindung liegt **die Aufgabe zu Grunde**, ein Verfahren vorzuschlagen, bei dem die Anwendung negativer Spannungen zum Löschen von Split-gate Flash-Speicherelementen nicht erforderlich ist, aber dennoch ein Tunneleffekt von Ladungsträgern aus dem Floating Gate genutzt wird.

Die Lösung dieser Aufgabe erfolgt mit den Merkmalen des Anspruchs 1. Eine vorteilhafte Weiterbildung ist vom Anspruch 2 erfasst.

Nach dem Grundgedanken der Erfindung wird das Split-gate Flash-Speicherelement in einer Wanne angeordnet, deren Leitfähigkeit dem des Halbleitersubstrates entspricht, in dem das Element normalerweise angeordnet ist. Um eine elektrische Isolierung vom Halbleitersubstrat zu erreichen, wird diese flache Wanne in einer tiefen Wanne angeordnet, deren Leitfähigkeit entgegengesetzt zu der flachen Wanne und dem Substrat ist. Damit erfolgt das Löschen des Speicherelements durch Anwendung verschieden hoher positiver Potentiale.

Nachfolgend wird die Erfindung anhand eines in der Zeichnung dargestellten Ausführungsbeispiels näher erläutert. Im Einzelnen zeigen die schematischen Darstellungen
- Fig. 1: als ein Querschnitt mit einem Beispiel eines Split-gate Flash- Speicherelementes;
- Fig. 2: als ein symbolisches Layout mit der Anordnung des Split-gate Flash- Speicherelementes.

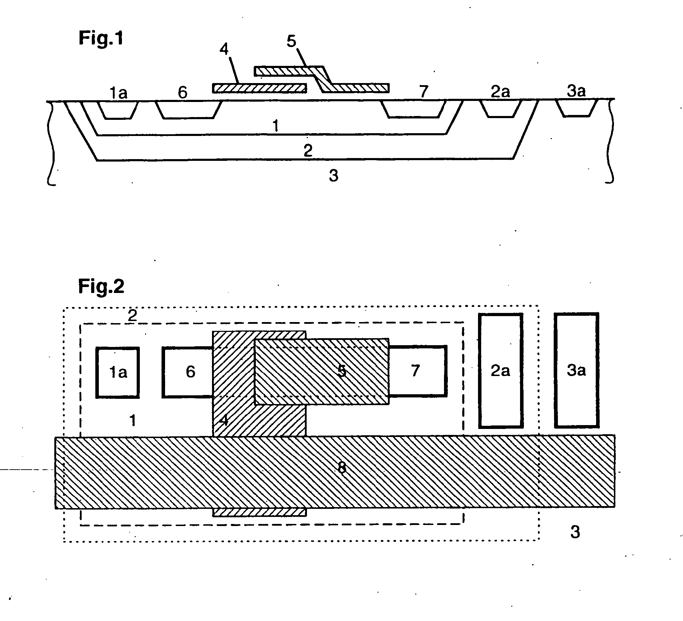

Der in Figur 1 dargestellte Querschnitt zeigt eine tiefe n-Wanne 2 in einem p-Halbleitersubstrat 3, wobei das Potential der n-Wanne 2 über einen niederohmigen n⁺-Anschluss 2a eingestellt werden kann. Das Substrat 3 hat ebenfalls in bestimmten Abständen niederohmige Anschlüsse 3a, über welche in allen Betriebsfällen eine Spannung von 0V eingespeist wird.

In der tiefen n-Wanne 2 ist eine flache p-Wanne 1 so angeordnet, dass diese an keiner Stelle elektrischen Kontakt mit dem Substrat 3 hat.

Das Potential der flachen p-Wanne 1 kann über den niederohmigen p⁺-Anschluss 1a eingestellt werden.

Im Gebiet der flachen p-Wanne 1 wird zumindest eine Split-gate Flash-Speicherzelle angeordnet, welches aus einem Floating Gate 4, einem Gate 5, welches einen Auswahltransistor bildet, und einem Program Gate 8, welches eine kapazitive Kopplung mit dem Floating Gate 4 bildet, besteht. Die zugehörigen, zu dem Floating Gate 4 und dem Program Gate 5 selbst justierten n⁺-Anschlüsse für Drain 6 und Source 7, sind in der flachen p-Wanne 1 so angeordnet, dass diese an keiner Stelle eine elektrische Verbindung zur tiefen n-Wanne 2 oder dem Substrat 3 haben.

Für das Lesen und Schreiben der Speicherzelle gelten dieselben Spannungs-Bedingungen an den Gates 4, 5 und 8 sowie den Source-/Drainanschlüssen 6 und 7, als wenn die zumindest eine Speicherzelle im Substrat 3 selbst angeordnet wäre. Das Potential der flachen p-Wanne 1 wird für beide Betriebsfälle auf 0V eingestellt und ist gleich dem Potential des Substrats 3. Die tiefe n-Wanne 2 wird für beide Betriebsfälle auf ein Potential von 5V angehoben, und ist damit gleich der Versorgungsspannung des Schaltkreises, in welchem die Speicherzelle eingesetzt wird.

Für das Löschen der Speicherzelle wird die tiefe n-Wanne 2 gemeinsam mit dem Drain 6 auf ein hohes positives Potential, zum Beispiel 13V, angehoben, während das Select Gate 5 und das Program Gate 8 auf 0V gehalten werden. Die flache p-Wanne 1 wird auf ein Potential von 8V angehoben. Damit existieren potentialmäßig dieselben Bedingungen wie bei der Speicherzelle im Substrat, allerdings werden von den Schaltungen zur Ansteuerung der zumindest einen Speicherzelle keine negativen Spannungen mehr verarbeitet.

Damit wird eine Verwendung komplementärer Schaltungstechniken möglich, was eine enorme Flächeneinsparung und Verlustleistungs-Reduzierung mit sich bringt.

## Patentansprüche

1. **Verfahren zum Löschen** eines Split-gate Flash-Speicherelementes, welches als zumindest eine Speicherzelle ein isoliertes erstes Poly-Siliziumgate als Floating Gate (4) aufweist, das durch ein Tunneloxid von einer Halbleiteroberfläche elektrisch getrennt ist, und mit einem zweiten Poly-Siliziumgate als Select Gate (5), welches teilweise über dem ersten Poly-Siliziumgate (4) angeordnet ist und durch ein Interpoly-Oxid von diesem elektrisch getrennt ist und weiterhin durch ein normales Gateoxid von der Halbleiteroberfläche isoliert ist, wodurch ein normaler n-Kanal Transistor gebildet wird, sowie mit einem dritten Poly-Siliziumgate als Program Gate (8), welches über Feldoxidgebiete über dem ersten Poly-Siliziumgate (4) angeordnet ist und ebenfalls durch ein Interpoly-Oxid elektrisch von diesem getrennt ist,
- wobei die Speicherzelle weiterhin je einen zum ersten (4) und zweiten Poly-Siliziumgate (5) selbstjustierten n⁺ Source- (7) und Drain-Anschluss (6) besitzt und in einer p-Wanne (1) angeordnet ist, deren Diffusionstiefe flach im Vergleich zu einer tiefen n-Wanne (2) ist, die in einem p-Substrat (3) angeordnet ist;
- wobei die p-Wanne (1) in der n-Wanne (2) so angeordnet ist, dass die p-Wanne (1) an keiner Stelle einen elektrischen Kontakt zu dem Substrat (3) hat;
- wobei der n⁺ Source- und Drain-Anschluss (6;7) so angeordnet sind, dass an keiner Stelle eine elektrische Verbindung zur tiefen n-Wanne (2) oder dem Substrat (3) besteht, und wobei - zum Löschen des Speicherelements - die tiefe n-Wanne (2) gemeinsam mit dem Drain-Anschluss (6) zumindest einer sich in der flachen Wanne (1) befindenden und zu löschenden Speicherzelle auf ein hohes positives Potential angehoben wird, das zweite und dritte Poly-Siliziumgate (5;8) auf Massepotential gelegt werden und die flache p-Wanne (1) auf ein positives Potential zwischen Masse und dem hohen Potential, welches am Drain-Anschluss (6) anliegt, gelegt wird, wodurch das Potential der flachen p-Wanne (1) in einem Bereich liegt, in welchem kein Durchbruch von Seiten des Drain-Anschlusses (6) oder des Select Gates (5) auftritt.

2. Verfahren nach Anspruch 1, wobei eine Vielzahl von Speicherzellen in der flachen p-Wanne (1) gemeinsam angeordnet sind, zur Bildung des gemeinsam zu löschenden Speicherelements.

## Claims

1. **Process** for deleting a split-gate flash memory element which has as at least one memory cell, an insulated first polysilicon gate as the floating gate (4), which is electrically separated from a semiconductor surface by a tunnel oxide, and with a second polysilicon gate (4) as the select gate (5), which is arranged partly above the first polysilicon gate (4) and is electrically separated from the latter by an interpolyoxide and also is insulated from the semiconductor surface by a normal gate oxide, as a result of which a normal n-channel transistor is formed, and with a third polysilicon gate as the program gate (8), which is arranged above field oxide areas over the first polysilicon gate (4) and is likewise separated electrically from the latter by an interpolyoxide,
- wherein the memory cell also has in each case an n* source (7) and drain connection (6) self-adjusted to the first (4) and second polysilicon gate (5) and is arranged in a p-well (1), the diffusion depth of which is shallow compared to a deep n-well (2) which is arranged in a p-substrate (3);
- wherein the p-well (1) is arranged in the n-well (2) so that the p-well (1) at no point has electrical contact with the substrate (3);
- wherein the n* source and drain connection (6; 7) are arranged so that at no point does an electrical connection with the deep n-well (2) or the substrate (3) exist, and wherein - to delete the memory element - the deep n-well (2) together with the drain connection (6) of at least one memory cell situated in the shallow well (1) and to be deleted, is raised to a high positive potential, the second and third polysilicon gate (5; 8) are placed at earth potential and the shallow p-well (1) is placed at a positive potential between earth and the high potential which exists at the drain connection (6), as a result of which the potential of the shallow p-well (1) is in an range in which no breakdown of sides of the drain connection (6) or of the select gate (5) occurs.

2. Process according to claim 1, wherein a plurality of memory cells are arranged together in the shallow p-well (1) to form the memory element to be deleted jointly.

## Revendications

1. Méthode d'effacement d'un élément de mémoire flash à grilles réparties, qui en tant qu'au moins une cellule de mémoire présente une première polygrille de silicium isolée comme grille flottante (4), qui est électriquement séparée d'une surface de semi-conducteur par un oxyde tunnel, et avec une deuxième polygrille de silicium comme grille de sélection (5), qui est disposée en partie au-dessus de la première polygrille de silicium (4) et est électriquement séparée de celle-ci par un inter-poly oxyde et est en outre isolée de la surface de semi-conducteur par un oxyde de grille normal, formant ainsi un transistor à canal n, ainsi qu'avec une troisième polygrille de silicium comme grille de programme (8), qui est disposée au-dessus de la première polygrille de silicium (4) au moyen de zones d'oxyde épais et est également séparée électriquement de celle-ci par un inter-poly oxyde,
- dans lequel la cellule de mémoire possède en outre chaque fois une borne source n⁺ (7) et une borne drain (6) auto-ajustées respectivement à la première (4) et à la deuxième (5) polygrille de silicium et est disposée dans une cuvette p (1), dont la profondeur de diffusion est plate par comparaison avec une cuvette n profonde (2), qui est disposée dans un substrat p (3) ;
- dans lequel la cuvette p (1) est disposée dans la cuvette n (2) de telle manière que la cuvette p (1) n'ait en aucun point un contact électrique avec le substrat (3) ;
- dans lequel la borne source n⁺ et la borne drain (6, 7) sont disposées de telle manière qu'il n'existe en aucun point une liaison électrique avec la cuvette n profonde (2) ou avec le substrat (3), et dans lequel - pour effacer l'élément de mémoire - la cuvette n profonde (2) avec la borne drain (6) d'au moins une cellule de mémoire se trouvant dans la cuvette plate (1) et à effacer est portée à un potentiel positif élevé, la deuxième et la troisième polygrilles de silicium (5; 8) sont mises au potentiel de la masse et la cuvette p plate (1) est portée à un potentiel positif situé entre la masse et le potentiel élevé, qui est appliqué à la borne drain (6), le potentiel de la cuvette p plate (1) se situant ainsi dans une plage dans laquelle il ne se produit aucun claquage du côté de la borne drain (6) ou de la grille de sélection (5).

2. Procédé selon la revendication 1, dans lequel une pluralité de cellules de mémoire sont disposées ensemble dans la cuvette p plate (1), pour former l'élément de mémoire à effacer en même temps.
